# DEMANDE DE BREVET EUROPEEN

(11) **EP 3 383 153 A1**
(43) Date de publication de la demande: **03.10.2018**
(21) Numéro de dépôt: 18160419.0
(22) Date de dépôt: 07.03.2018
(51) Int. Cl.: H05K 7/20, H05K 7/14, H05K 5/00

(54) **DISPOSITIF DE DISSIPATION DE CHALEUR D'UN DISPOSITIF ELECTRONIQUE**

(30) Priorité: 31.03.2017 FR 1752778
(71) Demandeur: Delphi International Operations Luxembourg S.à r.l., 4940 Bascharage (LU)
(72) Inventeur: RIEKE, Matthias, 41063 Moenchengladbach (DE); KLINK, Volker, 53773 HENNEF (DE); BADARAU-TRESCOVAN, Florin, 42857 Remscheid (DE)
(74) Mandataire: Robert, Vincent

(57) **Abrégé**

Un dispositif électronique (10) pour véhicule automobile comprend un boîtier tubulaire (12) métallique s'étendant longitudinalement et débouchant à ses deux extrémités (24, 26); le boitier tubulaire (12) comprenant une paroi (31) ayant un profil incurvé comportant des ailettes de refroidissement (34) sur sa surface extérieure (32). Le dispositif électronique (10) comprend également un ensemble de cartes à circuit imprimé (18) comportant une première pluralité (74) de cartes à circuit imprimé (74, 76) comprenant des composants électroniques (19) générant de la chaleur, les cartes à circuit imprimés (74, 76) de l'ensemble étant reliées entre elles par des éléments conducteurs flexible (92, 94). Le dispositif comprend également un premier dissipateur de chaleur (14) agencé à l'intérieur du boîtier tubulaire (12) comprenant une paroi (108) incurvée s'étendant globalement parallèlement à la paroi (31) incurvée du boîtier tubulaire (12). La première pluralité (74) de cartes à circuit imprimé (74, 76) est intercalée entre la surface intérieure (48) incurvée de la paroi (31) du boîtier (12) et la paroi (108) incurvée du premier dissipateur de chaleur (14) de sorte à pouvoir dissiper la chaleur au travers du premier dissipateur de chaleur (14) et de la paroi (31) incurvée équipée d'ailettes de refroidissement (34) du boîtier tubulaire (12).

## Description

### DOMAINE TECHNIQUE

L'invention concerne le domaine des dispositifs électroniques pour véhicule automobile. Plus particulièrement, l'invention concerne un dispositif de dissipation de chaleur pour un dispositif électronique.

### ARRIERE-PLAN TECHNOLOGIQUE DE L'INVENTION

Les unités de commande électronique automobile actuelles et à venir présentent une densité de puissance accrue et des dimensions de boîtier de plus en plus compactes en raison de l'espace restreint disponible dans les véhicules automobiles.

Certain composants électroniques sont des composants produisant de la chaleur. Il peut s'agir de microcontrôleurs dont la vitesse de traitement de donnée est telle que le microcontrôleur chauffe lors de ses opérations, ou encore par exemple, il peut s'agir de composants électroniques distribuant de forts courants électriques aux équipements du véhicule, ou encore simplement de pistes conductrices véhiculant de forts courants à travers la carte à circuit imprimé.

Afin de refroidir ces composants pour éviter leur défaillance, il est connu de dissiper leur chaleur en couplant directement thermiquement ces composants à un boîtier thermo conducteur du dispositif. Généralement, afin de garantir un couplage thermique permanent lors notamment du roulage du véhicule dans lequel le dispositif est embarqué et soumis à des vibrations, les composants sont montés sur une carte à circuit imprimé agencé en fond de boîtier, des zones protubérantes du couvercle du boîtier venant en appuis sur les composants de sorte à servir de radiateur de refroidissement des composants.

Il est apparu que de tels dispositifs sont encombrants. De plus, la rigidité de tels dispositifs entraine des défaillances des composants refroidis, notamment des cassures de soudures des composants ou encore un endommagement du composant entrainant une défaillance de celui-ci.

Il est donc important de proposer une solution nouvelle résolvant ces problèmes.

### RESUME DE L'INVENTION

Un dispositif électronique pour véhicule automobile comprend un boîtier tubulaire métallique s'étendant longitudinalement et débouchant à ses deux extrémités; le boitier tubulaire comprenant une paroi ayant un profil incurvé comportant des ailettes de refroidissement sur sa surface extérieure. Le dispositif électronique comprend également un ensemble de cartes à circuit imprimé comportant une première pluralité de cartes à circuit imprimé comprenant des composants électroniques générant de la chaleur, les cartes à circuit imprimés de l'ensemble étant reliées entre elles par des éléments conducteurs flexible. Le dispositif électronique comprend également un premier dissipateur de chaleur agencé à l'intérieur du boîtier tubulaire comprenant une paroi incurvée s'étendant globalement parallèlement à la paroi incurvée du boîtier tubulaire. La première pluralité de cartes à circuit imprimé est intercalée entre la surface intérieure incurvée de la paroi du boîtier et la paroi incurvée du premier dissipateur de chaleur de sorte à pouvoir dissiper la chaleur au travers du premier dissipateur de chaleur et de la paroi incurvée équipée d'ailettes de refroidissement du boîtier tubulaire.

L'ensemble de cartes à circuit imprimé peut comprendre une carte à circuit imprimé plane distincte de la première pluralité ; une première face de la dite carte à circuit imprimé plane étant agencée contre une paroi plane du premier dissipateur de chaleur. L'ensemble de cartes à circuit imprimé peut comprendre une seconde pluralité de cartes à circuit imprimé comprenant des composants électroniques générant de la chaleur. Le dispositif électronique peut comprendre un second dissipateur de chaleur comprenant une autre paroi plane agencée contre la seconde face de la carte à circuit imprimé plane. La seconde pluralité de cartes à circuit imprimé peut être intercalée entre la surface intérieure incurvée de la paroi du boîtier tubulaire et une paroi incurvée du second dissipateur de chaleur de sorte à pouvoir dissiper la chaleur au travers du second dissipateur de chaleur et de la paroi incurvée équipée d'ailettes de refroidissement du boîtier tubulaire.

Chaque dissipateur de chaleur peut comprendre d'autres ailettes de refroidissement s'étendant vers l'axe central du boîtier tubulaire. Chaque dissipateur de chaleur peut s'étendre longitudinalement contre les cartes à circuit imprimés de l'ensemble des cartes à circuit imprimés.

Le dispositif électronique peut comporter un moyen de ventilation agencé à une des deux extrémités du boîtier tubulaire de sorte à pouvoir générer un flux d'air selon la direction longitudinale. L'ensemble des cartes à circuit imprimés peut s'étendre longitudinalement sur toute la longueur du boîtier. Le boîtier tubulaire peut être formé par deux demi-cylindres à base circulaire et de même dimensions comprenant sur leur surface extérieure les ailettes de refroidissement, les deux demi-cylindres étant agencés l'un sur l'autre de sorte à former un boîtier cylindrique à base circulaire. Une carte à circuit imprimé peut comprendre un connecteur s'étendant à l'extérieur du boîtier tubulaire à travers la paroi incurvée du boîtier tubulaire. Le connecteur peut comprendre des broches assemblées sur la carte à circuit imprimé plane, le corps du connecteur étant agencé au travers d'une ouverture de la paroi incurvée du boîtier.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique éclatée en perspective du dispositif électronique selon l'invention
- La figure 2 est une vue schématique en perspective du dispositif électronique assemblé de la figure 1.
- La figure 3 est une vue schématique en perspective de l'ensemble de cartes à circuit imprimé du dispositif électronique de la figure 1.
- La figure 4 est une vue schématique de l'ensemble des cartes à circuits imprimés agencé dans le boîtier tubulaire du dispositif électronique de la figure 1.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale.

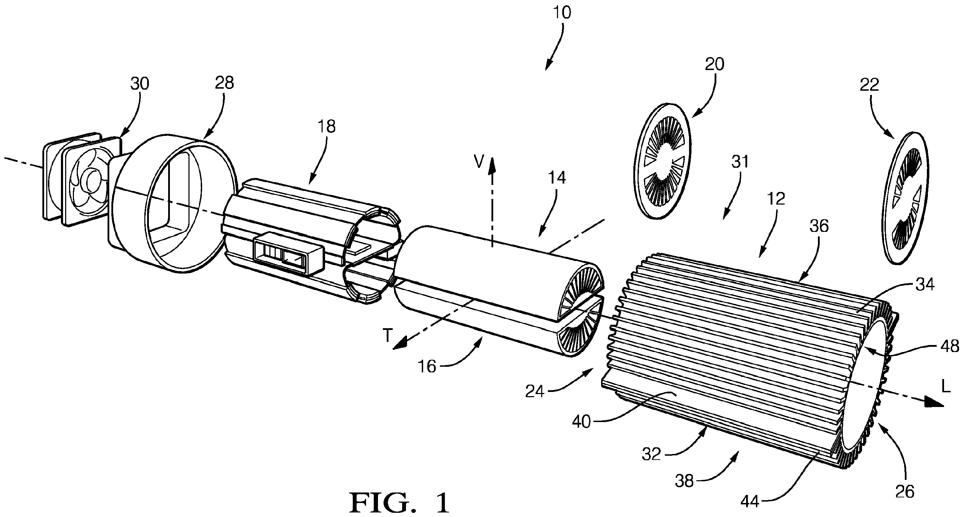

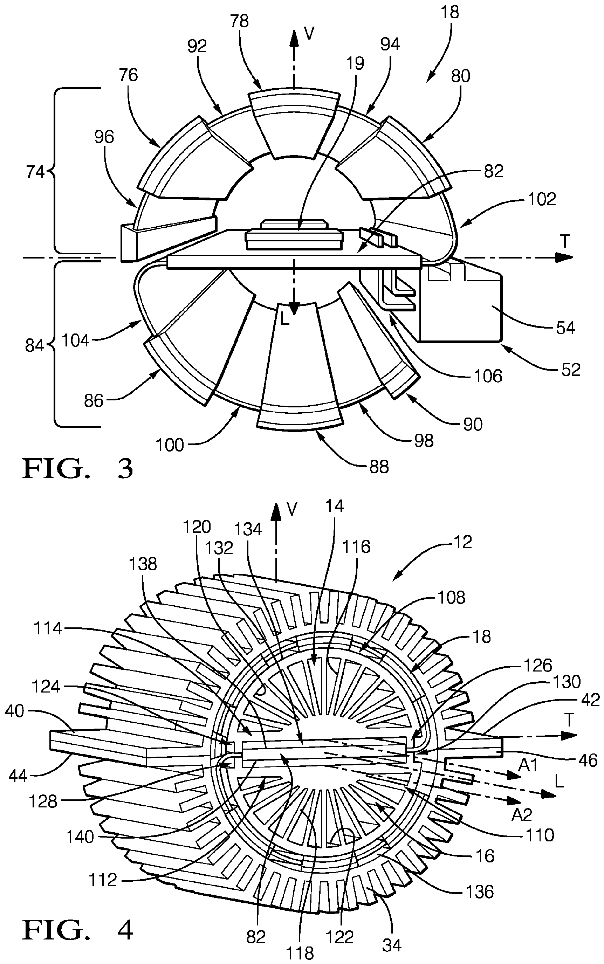

Selon la figure 1, un dispositif électronique 10 pour véhicule automobile comprend un boîtier tubulaire 12 s'étendant selon l'axe longitudinal L, un premier dissipateur de chaleur 14 et un second dissipateur de chaleur 16 prévus pour être agencés à l'intérieur du boîtier tubulaire 12. Le dispositif électronique comprend également un ensemble de cartes à circuit imprimé 18 comprenant au moins un composant électronique 19 (visible à la figure 3) pouvant générer de la chaleur, l'ensemble de cartes à circuit imprimé 18 étant prévu pour être intercalé entre le boîtier tubulaire 12 et chaque dissipateur de chaleur 14, 16. Le dispositif électronique 10 comprend également une première grille de ventilation 20 et une deuxième grille de ventilation 22 prévues pour être agencées à chaque extrémité 24, 26 du boîtier tubulaire 12.

Le dispositif électronique 10 comprend également un support de ventilateur 28 prévue pour être agencé contre la première grille de ventilation 20, et également un ventilateur 30 prévu pour être agencé dans son support 28 et prévu pour générer un flux d'air selon la direction longitudinale.

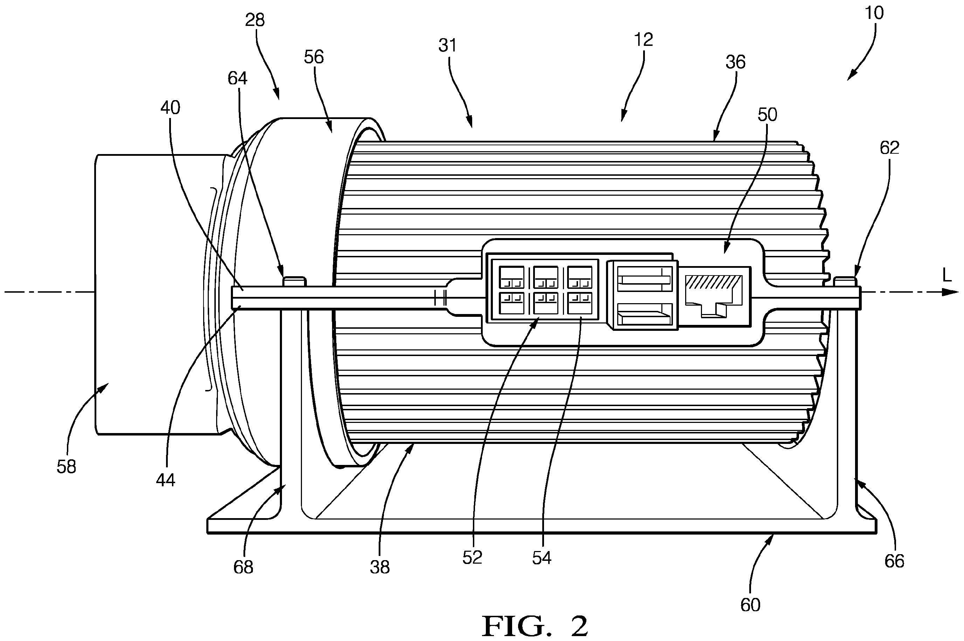

Selon la figure 1 et la figure 2, le boîtier tubulaire 12 est un cylindre creux débouchant à chacune de ses deux extrémités 24, 26. Plus particulièrement, le boîtier tubulaire est de forme cylindrique à base circulaire.

La surface extérieure 32 de la paroi 31 du boîtier tubulaire 12 est équipée d'ailettes de refroidissement 34 s'étendant également longitudinalement. Bien que pouvant être réalisé d'une seule pièce, selon le mode de réalisation représenté, le boîtier tubulaire 12 est composé de deux demi-cylindres 36, 38 assemblés. L'assemblage est réalisé au moyen de deux premières ailettes de fixation 40, 42 (voir figure 4) agencées de part et d'autre de la surface extérieure 32 d'un des demi-cylindres 36 et fixées à deux secondes ailettes de fixation 44, 46 agencées de part et d'autre de la surface extérieure 32 de l'autre demi-cylindre 38. Les ailettes de fixations 40, 42, 44, 46 sont comparables aux ailettes de refroidissement 34, puisqu'elles sont également métalliques et s'étendent de façon similaire. Cependant, elles s'étendent plus largement selon une direction orthogonale au boîtier tubulaire 12 de sorte à pouvoir y agencer des moyens de fixations tels que par exemple des vis.

La surface intérieure 48 de la paroi 31 du boîtier tubulaire 12 est globalement lisse. La courbure de la surface intérieure 48 de la paroi 31 du boîtier tubulaire 12 est globalement circulaire.

Selon le mode de réalisation représenté à la figure 2, le boîtier tubulaire 12 comprend également une ouverture 50 permettant l'agencement de connecteurs électriques 52 prévus pour être reliés électriquement à l'ensemble de cartes à circuit imprimé 18. L'ouverture 50 est agencée à la jointure des deux demi-cylindres 36, 38 du boîtier tubulaire 12. L'ouverture 50, est globalement de forme complémentaire au corps 54 des connecteurs électriques 52. L'ouverture 50 vient donc créer une discontinuité sur les ailettes de fixations 40, 44. Le support de ventilateur 28 est une pièce comportant une partie globalement cylindrique à base circulaire 56 venant s'agencer autour du boîtier tubulaire 12 et une partie globalement cylindrique 58 de base rectangulaire dans laquelle le ventilateur 30 est agencé. Le ventilateur 30 est agencé en vis-à-vis direct de la première grille de ventilation 20 de sorte à pouvoir générer un flux d'air traversant le boîtier tubulaire 12 selon la direction longitudinale et donc favorisant la circulation du flux d'air de refroidissement. Selon la direction du flux d'air, l'extraction de l'air chaud généré par le composant électronique générant de la chaleur se fait au travers de la seconde grille de ventilation 22.

Egalement, selon la figure 2, à des fins de fixation, le dispositif électronique est monté sur un support ou socle 60. Plus précisément, les ailettes de fixation du boîtier tubulaire 40, 44 comprennent des ouvertures 62, 64 dans lesquelles viennent s'insérer des plots de fixations 66, 68 du socle 60.

Les moyens de fixations 66, 68 représentés selon la figure 2 ne sont pas limitatifs à l'invention. D'autres moyens de fixation du dispositif électronique 10 dans un véhicule sont envisageables. Le boîtier tubulaire 12 peut par exemple comprendre des pattes de fixation sur sa surface extérieure 32 permettant le montage du dispositif électronique 10 directement dans le véhicule et donc sans socle 60 additionnel.

Selon la figure 1 et la figure 3, l'ensemble de cartes à circuit imprimé 18 comprend une première pluralité 74 de cartes à circuit imprimé 76, 78, 80 reliée électriquement à une carte à circuit imprimé plane 82 agencée selon un plan horizontal défini par l'axe longitudinal L et l'axe transversal T. L'ensemble de cartes à circuit imprimé 18 comprend également une seconde pluralité 84 de cartes à circuit imprimé 86, 88, 90 reliée électriquement à la carte à circuit imprimé plane 82.

Les cartes à circuit imprimé 76, 78, 80 de la première pluralité 74 ainsi que les cartes à circuit imprimés 86, 88, 90 de la seconde pluralité 84 sont des cartes à circuit imprimés souples agencées consécutivement les unes après les autres. Les cartes à circuit imprimé 76, 78, 80 de la première pluralité 74 agencées consécutivement l'une après l'autre ainsi que les cartes à circuit imprimés 86, 88, 90 de la seconde pluralité 84 agencées consécutivement l'une après l'autre sont reliées entre elles par des éléments conducteurs flexibles 92, 94, 96, 98, 100 telles que des nappes de fils électriques ou encore par des cartes à circuit imprimé flexibles (ou encore Flex-PCB en terme anglo-saxon) comprenant généralement un substrat plastique. Les cartes à circuit imprimé 76, 78, 80 de la première pluralité 74 ainsi que les cartes à circuit imprimés 86, 88, 90 de la seconde pluralité 84 comprennent donc des cartes à circuit imprimés 76, 78, 80, 86, 88, 90 suffisamment souples de sorte à pouvoir s'agencer contre la surface intérieure 48 du boîtier tubulaire 12.

La première pluralité 74 de cartes à circuit imprimé 76, 78, 80 vient donc s'agencer de manière courbée par-dessus la carte à circuit imprimé plane 82. La seconde pluralité 84 de cartes à circuit imprimé 86, 88, 90 vient donc également s'agencer de manière courbée par-dessous la carte à circuit imprimé plane 82.

La carte à circuit imprimé plane 82 est globalement de forme rectangulaire. Un premier bord de la carte à circuit imprimé plane 82 est relié électriquement à la carte à circuit imprimé 80 de la première pluralité 74 la plus proche dudit premier bord par un autre élément conducteur flexible 102. Un second bord de la carte à circuit imprimé plane 82, opposé au premier bord, est relié électriquement à la carte à circuit imprimé 86 de la seconde pluralité 84 la plus proche dudit second bord par encore un autre élément conducteur flexible 104 distinct de celui du premier bord.

Les cartes à circuits imprimé 76, 78, 80, 82, 86, 88, 90 de l'ensemble de cartes à circuit imprimé 18 sont de forme globalement rectangulaire et s'entendent longitudinalement tout le long du boiter tubulaire 12. Les cartes à circuit imprimé 76, 78, 80 de la première pluralité 74, les cartes à circuit imprimé 86, 88, 90 de la seconde pluralité 84 et la carte à circuit imprimé plane 82 peuvent être équipées de composants électroniques 19 générant de la chaleur. De préférence, les composants électroniques fragiles à un stress mécanique du à la flexion des cartes à circuit imprimé, sont agencés sur la carte à circuit imprimé plane 82. Par exemple et de façon non limitative, les composants électroniques en boîtier comprenant des matrices de billes (boîtier BGA selon le terme anglo-saxon), seront de préférence montés sur la carte à circuit imprimé plane 82. D'autres composants générateurs de chaleur et moins fragiles au stress mécanique des cartes à circuits imprimé, tels que par exemple des interrupteurs de puissances de type composants montés en surface et de boîtier de type D2Pack, comprenant une semelle métallique de connexion et une série de broches de connexion, peuvent être agencé sur les cartes à circuit imprimés souples 76, 78, 80 de la première pluralité 74 et de la seconde pluralité 84 de cartes à circuit imprimé.

Selon la figure 3, le connecteur électrique 52 est agencé sur la carte à circuit imprimé plane 82. Les broches 106 du connecteur 52 sont des broches coudées permettant ainsi l'agencement du corps 54 du connecteur 52 au travers de l'ouverture 50 de la paroi 31 cylindrique du boîtier tubulaire 12. Les extrémités des broches 106 du connecteur 52 hors de son corps 54 sont montées sur la carte à circuit imprimé plane 82. Elles peuvent être soit soudées ou encore insérées en force dans la carte à circuit imprimé plane 82.

Il est également possible d'équiper les cartes à circuit imprimé 76, 78, 80, 86, 88, 90 de la première et de la seconde pluralité 74, 84, de connecteurs électriques droits, c'est-à-dire ayant des broches droites non coudées, de sorte que les boîtiers des connecteurs droits puissent être agencés au travers d'autres ouvertures de la paroi du boîtier tubulaire 12.

Afin de faciliter la description de l'agencement de l'ensemble de cartes à circuit imprimé 18 dans le boîtier tubulaire 12, l'illustration de la figure 4 ne fait pas apparaitre les connecteurs 52 visibles sur la figure 2 et la figure 3.

Selon la figure 1 et la figure 4, le premier dissipateur de chaleur 14 et le second dissipateur 16 de chaleur sont des demi-cylindres s'étendant longitudinalement selon une longueur similaire au boîtier tubulaire 12.

Chaque dissipateur de chaleur 14, 16 comprend une paroi semi cylindrique 108, 110 et une paroi plane 112, 114 reliant chaque extrémité de la paroi semi-cylindrique 108, 110. Chaque dissipateur de chaleur 14, 16 comprend d'autres ailettes de refroidissement 116, 118 réparties globalement régulièrement sur la surface intérieure 120, 122 de la paroi semi-cylindrique 108, 110 et s'étendant d'une part longitudinalement tout le long de la paroi semi cylindrique 108, 110 et d'autre part depuis la surface intérieure 120, 122 de chaque paroi semi-cylindrique 108, 110 desdits dissipateurs de chaleur 14, 16 vers l'axe central L du boîtier tubulaire 12. Plus précisément, les autres ailettes de refroidissement 116, 118 s'tendent d'autre part depuis la surface intérieure 120, 122 de chaque paroi semi-cylindrique 108, 110 desdits refroidisseurs de chaleur 14, 16 vers l'axe central A1, A2 du semi-cylindre dudit refroidisseur de chaleur 14, 16.

Le premier et le second dissipateur de chaleur 14, 16 sont agencés en miroir l'un sur l'autre de manière à former globalement un ensemble de dissipateur de chaleur de forme cylindrique à base circulaire. La paroi plane 114 du premier dissipateur de chaleur 14 est donc agencée en regard de la paroi plane 112 du second dissipateur de chaleur 16 et parallèlement à celle-ci.

Selon la figure 4, les parois planes 112, 114 des dissipateurs de chaleur 14, 16 sont espacés l'une de l'autre par des piliers 124, 126, 128, 130 créant ainsi un espace 132 dans lequel est agencé la carte à circuit imprimé plane 82. La face de dessus 138 et la face de dessous 140 de la carte à circuit imprimé plane 82 sont en appui respectivement sur la paroi plane 114 du premier dissipateur de chaleur 14 et sur la paroi plane 112 du second dissipateur de chaleur 16. L'espace 132 entre la carte à circuit imprimé plane 82 et les parois planes 112, 114 des dissipateurs de chaleur 14, 16 peut être comblé par de la pâte thermique, la pâte thermique garantissant l'appui de la carte à circuit imprimé plane 82 contre les deux parois planes 112, 114.

Le rayon de courbure de chaque paroi semi-cylindrique des dissipateurs de chaleur 14, 16 est dimensionné de sorte que chaque pluralité 74, 84 de cartes à circuit imprimé est intercalée entre la surface intérieure 48 du boîtier tubulaire 12 et la surface extérieure 134, 136 de la paroi semi-cylindrique 108, 110 des dissipateurs de chaleur 14, 16. Autrement dit, la première pluralité 74 de carte à circuit imprimé 76, 78, 80 et la seconde pluralité 84 de carte à circuit imprimé 86, 88, 90 sont respectivement en appui contre la surface extérieure 134, 136 de la paroi semi-cylindrique 108, 110 du premier dissipateur de chaleur 14 et du second dissipateur de chaleur 16; et également en appui contre sur la surface intérieure 48 du boîtier tubulaire 12.

Afin de limiter le stress mécanique sur les cartes à circuit imprimé 76, 78, 80, 86, 88, 90 de la première et de la seconde pluralité 74, 84, le premier et le second dissipateur de chaleur 14, 16 peuvent comprendre des méplats en vis-à-vis de méplats agencés sur la surface intérieure 48 du boîtier tubulaire 12. Les cartes à circuit imprimés 76, 78, 80, 86, 88, 90 de la première et de la seconde pluralité 74, 84 peuvent s'intercaler entre les méplats des dissipateurs de chaleur 14, 16 et les méplats de la surface intérieure 48 du boîtier tubulaire 12 de sorte à ne pas s'incurver.

L'invention peut également se décliner en diverses alternatives reprenant notamment le principe d'intercaler des cartes à circuit imprimé entre la surface intérieure incurvée d'un boîtier métallique et la surface extérieure incurvée d'un dissipateur de chaleur, la forme incurvée du dispositif électronique ainsi obtenue permettant l'agencement de cartes à circuit imprimé entre deux structures métalliques et permettant une dissipation thermique optimale, la forme incurvée du dispositif électronique permettant un gain de place d'un tel dispositif.

## Revendications

1. Dispositif électronique (10) pour véhicule automobile comprenant :
un boîtier tubulaire (12) métallique s'étendant longitudinalement et débouchant à ses deux extrémités (24, 26); le boitier tubulaire (12) comprenant une paroi (31) ayant un profil incurvé comportant des ailettes de refroidissement (34) sur sa surface extérieure (32);
un ensemble de cartes à circuit imprimé (18) comportant une première pluralité (74) de cartes à circuit imprimé (74, 76) souples comprenant des composants électroniques (19) générant de la chaleur, les cartes à circuit imprimés (74, 76) de l'ensemble étant reliées entre elles par des éléments conducteurs flexible (92, 94);
un premier dissipateur de chaleur (14) agencé à l'intérieur du boîtier tubulaire (12) comprenant une paroi (108) incurvée s'étendant globalement parallèlement à la paroi (31) incurvée du boîtier tubulaire (12);
la première pluralité (74) de cartes à circuit imprimé (74, 76) étant intercalée entre la surface intérieure (48) incurvée de la paroi (31) du boîtier (12) et la paroi (108) incurvée du premier dissipateur de chaleur (14) de sorte à pouvoir dissiper la chaleur au travers du premier dissipateur de chaleur (14) et de la paroi (31) incurvée équipée d'ailettes de refroidissement (34) du boîtier tubulaire (12) ;
l'ensemble de cartes à circuit imprimé (18) comprenant une carte à circuit imprimé plane (82) distincte de la première pluralité (74), une première face (138) de la dite carte à circuit imprimé plane (82) étant agencée contre une paroi plane (114) du premier dissipateur de chaleur (14).

2. Dispositif électronique (10) selon la revendication 1 **caractérisé en ce que** :
l'ensemble de cartes à circuit imprimé (18) comprend une seconde pluralité (84) de cartes à circuit imprimé (86, 88) souples comprenant des composants électroniques (19) générant de la chaleur;
un second dissipateur de chaleur (16) comprend une autre paroi plane (112) agencée contre la seconde face (140) de la carte à circuit imprimé plane (82);
la seconde pluralité (84) de cartes à circuit imprimé (86, 88) est intercalée entre la surface intérieure (48) incurvée de la paroi (31) du boîtier tubulaire (12) et une paroi incurvée (110) du second dissipateur de chaleur (16) de sorte à pouvoir dissiper la chaleur au travers du second dissipateur de chaleur (16) et de la paroi (31) incurvée équipée d'ailettes de refroidissement (34) du boîtier tubulaire (12).

3. Dispositif électronique (10) selon l'une quelconque des revendications précédentes **caractérisé en ce que** chaque dissipateur de chaleur (14, 16) comprend d'autres ailettes de refroidissement (116, 118) s'étendant vers l'axe central (L) du boîtier tubulaire (12).

4. Dispositif électronique (10) selon l'une quelconque des revendications précédentes **caractérisé en ce que** chaque dissipateur de chaleur (14, 16) s'étend longitudinalement contre les cartes à circuit imprimés de l'ensemble des cartes à circuit imprimés (18).

5. Dispositif électronique (10) selon l'une quelconque des revendications précédentes **caractérisé en ce qu'**il comporte un moyen de ventilation (30) agencé à une des deux extrémités (24) du boîtier tubulaire (12) de sorte à pouvoir générer un flux d'air selon la direction longitudinale.

6. Dispositif électronique (10) selon l'une quelconque des revendications précédentes **caractérisé en ce que** l'ensemble des cartes à circuit imprimés (18) s'étend longitudinalement sur toute la longueur du boîtier tubulaire (12).

7. Dispositif électronique (10) selon l'une quelconque des revendications précédentes **caractérisé en ce que** le boîtier tubulaire (12) est formé par deux demi-cylindres (36, 38) à base circulaire et de même dimensions comprenant sur leur surface extérieure (32) les ailettes de refroidissement (34), les deux demi-cylindres (36, 38) étant agencés l'un sur l'autre de sorte à former un boîtier cylindrique à base circulaire.

8. Dispositif électronique (10) selon l'une quelconque des revendications précédentes **caractérisé en ce qu'**une carte à circuit imprimé (82) comprend un connecteur (52) s'étendant à l'extérieur du boîtier tubulaire (12) à travers la paroi (31) incurvée du boîtier tubulaire (12).

9. Dispositif électronique (10) selon la revendication 8 **caractérisé en ce que** le connecteur (52) comprend des broches (106) assemblées sur la carte à circuit imprimé plane (82), le corps (54) du connecteur (52) étant agencé au travers d'une ouverture (50) de la paroi (31) incurvée du boîtier (12).
